# EUROPÄISCHE PATENTSCHRIFT

(11) **EP 0 540 955 B1**
(45) Veröffentlichungstag und Bekanntmachung des Hinweises auf die Patenterteilung: **27.03.1996**
(21) Anmeldenummer: 92118146.7
(22) Anmeldetag: 23.10.1992
(51) Int. Cl.: H05K 3/30, H05K 7/12

(54) **Vorrichtung zum Befestigen eines stabförmigen Dauermagneten**
Device for fastening a bar-shaped permanent magnet
Dispositif pour fixer un aimant permanent en forme de barre

(30) Priorität: 06.11.1991 DE 9113780 U
(43) Veröffentlichungstag der Anmeldung: 12.05.1993
(73) Patentinhaber: VDO Adolf Schindling AG, D-60326 Frankfurt/Main (DE)
(72) Erfinder: Hautvast, Heinz-Josef, Dipl.-Ing. (FH), W-7734 Brigachtal (DE)

(56) Entgegenhaltungen:
- EP-A- 0 177 798
- DE-A- 3 844 310

## Beschreibung

Die Erfindung betrifft einen Halter zum Befestigen eines stabförmigen Dauermagneten auf einer Platine, insbesondere auf einer Leiterplatte. Ein solcher Halter ist eine an sich untypische Maßnahme, da es sich bei einem Dauermagneten um ein nichtelektrisches Bauelement handelt, das demnach nicht mit Kontaktstiften versehen ist, die in der Regel bei elektrischen Bauteilen nicht allein der Kontaktierung mit den auf der Leiterplatte vorgesehenen Leiterbahnen sondern auch der mechanischen Befestigung des betreffenden Bauteils dienen.

Ist ein derartiger Dauermagnet Teil eines magnetfeldgesteuerten Oszillators, dessen Schwingkreisspule einen magnetischen Sensor darstellt, d. h. die Meßwertbildung durch Änderung der magnetischen Eigenschaften der Schwingkreisspule bzw. deren Spulenkerns erfolgt und der Dauermagnet der Vormagnetisierung, mit anderen Worten der Arbeitspunkteinstellung des magnetischen Sensors dient, ist eine geeignete räumliche Zuordnung von Schwingkreisspule und Dauermagnet erforderlich.

Wird in einem solchen Falle zweckmäßigerweise die Schwingkreisspule unmittelbar und somit leitungsfrei auf einer zentralen, die Mittel zur Meßwertaufbereitung und -verarbeitung sowie weitere elektronische Funktionsgruppen tragenden Leiterplatte eines Meß-, Steuer- oder Datenerfassungsgerätes angeordnet, hat dies zur Folge, daß der Dauermagnet ebenfalls auf dieser Leiterplatte zu befestigen ist. Dabei sind die üblichen Befestigungsmethoden nicht anwendbar. Ein Festschrauben beispielsweise mittels einer mit der betreffenden Leiterplatte verschraubten Schelle oder Haltebrücke beansprucht ein erhebliches Leiterplattenareal, das nicht mit Leiterbahnen belegt werden kann. Außerdem ist eine derartige Befestigung insofern ungeeignet, weil sie nicht in den Bestückungsfluß einer Leiterplatte paßt. Ein Befestigen des Dauermagneten durch unmittelbares Kleben auf die Leiterplatte läßt, vom Erfordernis einer relativ exakten Positionierung des Dauermagneten abgesehen, kein Nachjustieren zu und bedingt Fertigungsverzögerungen durch Einhalten von Reaktionszeiten des Klebers.

DE-A- 38 44 310 offenbart eine Halterung für freistehende elektronische Bauteile, wobei eine Grundplatte vorgesehen ist und von den Schmalseiten der Grundplatte ausgehende, freitragende Haltearme, die in in eine Leiterplatte einsteckbare Befestigungsstifte übergehen, vorgesehen sind.

Die Aufgabe der vorliegenden Erfindung besteht somit darin, einen Halter zu schaffen, der eine Befestigung eines Dauermagneten auf einer Leiterplatte unter Großserienbedingungen gestattet.

Der erfindungsgemäße Halter ist in Anspruch 1 definiert.

Die Lösung dieser Aufgabe sieht u.a. vor, daß ein den Dauermagneten aufnehmender Halter vorgesehen ist und daß der Halter mit der Leiterplatte rastend verbindbar ist.

Ein bevorzugtes Ausführungsbeispiel ist dadurch gekennzeichnet, daß der Halter im wesentlichen U-förmig profiliert ist und zwei Fixierzapfen und wenigstens eine Rastklinke an der den Schenkeln des U-Profils entgegengesetzten Seite des Halters ausgebildet sind.

Der Vorteil, den die Erfindung bietet, ist darin zu sehen, daß ein stabförmiger Dauermagnet mittels des lösungsgemäßen Halters sozusagen im Zuge der Bestückung einer Leiterplatte montiert werden kann und aufgrund der vorgesehenen Rastverbindung letzten Endes maschinell montierbar ist. Dabei läßt der möglichst große, gegenseitige Abstand der Fixierzapfen die bei Leiterplattenbohrungen üblichen, für die Bestückung aber auch notwendigen, relativ groben Toleranzen zu, während insbesondere die U-förmige Ausbildung sowohl ein Austauschen oder nachträgliches Einsetzen als auch ein leichtes Justieren und Befestigen des Dauermagneten durch Kleben gestattet. Ferner bewirkt die Bauform des Halters einen rüttelsicheren Sitz des Dauermagneten und somit eine Eignung für die Verwendung im Kraftfahrzeug.

Im folgenden sei die Erfindung anhand der Zeichnungen näher erläutert. Es zeigen
Fig. 1 eine perspektivische Übersichtsdarstellung der erfindungsgemäßen Anordnung,
Fig. 2 eine perspektivische Darstellung eines bevorzugten Ausführungsbeispiels des Halters,
Fig. 3 einen Schnitt des Halters gemäß dem mit der Fig. 2 dargestellten Ausführungsbeispiel,
Fig. 4 einen Längsschnitt eines weiteren Ausführungsbeispiels des Halters,
Fig. 5 einen Querschnitt des Halters gemäß Fig. 4,
Fig. 6 eine Draufsicht auf den Halter gemäß Fig. 2, wobei im Halter zwei Dauermagnete aufgenommen sind.

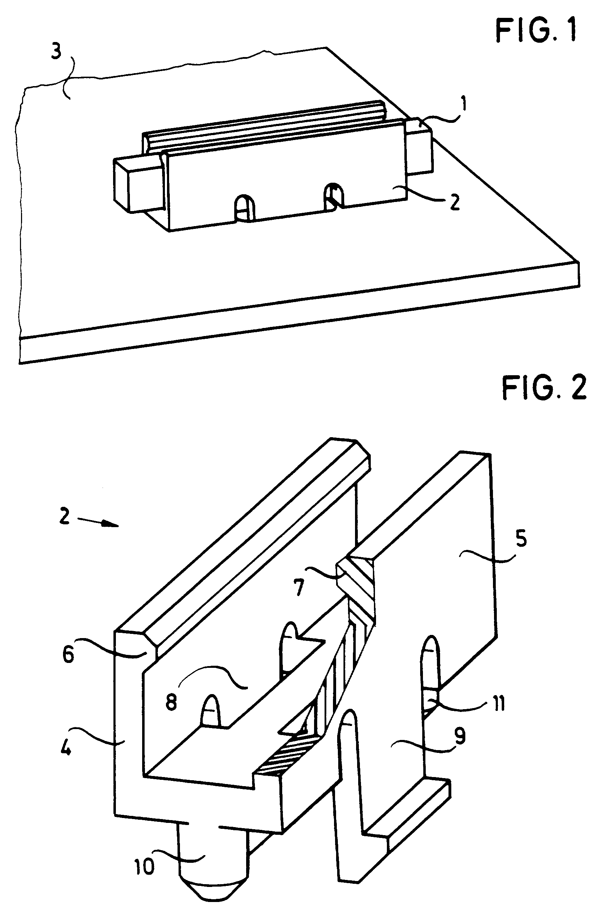

Gemäß Fig. 1 ist ein Dauermagnet 1 in einem U-förmigen Halter 2 befestigt, wobei letzterer auf einer Leiterplatte 3 angeordnet ist.

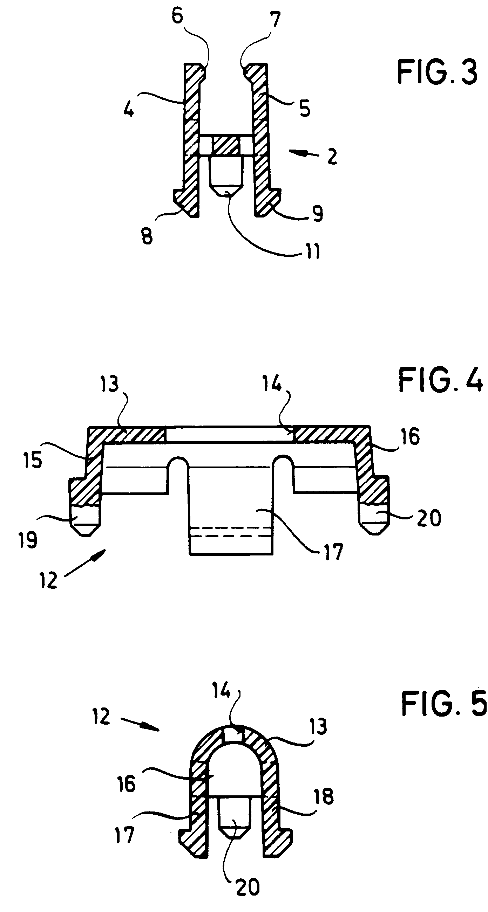

Wie aus der Fig. 2 und der Schnittdarstellung Fig. 3 ersichtlich ist, sind an den Schenkeln 4 und 5 des U-förmigen Halters 2 nach innen weisende Rippen 6 und 7 angeformt, die zusammen mit einer gewissen Federungsfähigkeit der Schenkel 4 und 5 eine Halterung eines eingesetzten Dauermagneten 1 und somit auch eine maschinelle Handhabung einer aus dem Dauermagneten 1 und dem Halter 2 vormontierten Baugruppe gestatten. Außerdem ist der Halter 2 mit Rastklinken 8 und 9 sowie mit Fixierzapfen 10 und 11 versehen. Diese Ausbildung bedingt geeignete Bohrungen für die Fixierzapfen 10 und 11 sowie den Rastklinken 8 und 9 zugeordnete Schlitze in der Leiterplatte 3, auf welcher der Halter 2 unmittelbar aufsitzt. Die Höhe des Dauermagneten 1 über der Leiterplatte 3 wird dabei durch die Stärke des die Schenkel 4 und 5 verbindenden, nicht näher bezeichneten Steges des Halters 2 bestimmt.

Denkbar ist in diesem Zusammenhang auch die Anordnung auf einer Platine oder Leiterplatte, auf der im wesentlichen nur die Bauelemente des betreffenden Sensors angeordnet sind und die mittels einer geeigneten, mechanisch zweckdienlichen Steckverbindung mit der Leiterplatte 3 verbunden ist oder an einer anderen Stelle des betreffenden Gerätes befestigt und mit der Leiterplatte 3 in geeigneter Weise verdrahtet ist.

Die Fig. 4 und 5 zeigen einen Halter 12, an welchem anstatt des U-Profils zur Aufnahme vorzugsweise eines Dauermagneten 1 mit rechteckförmigem Querschnitt eine insbesondere für die Halterung eines zylindrischen Dauermagneten geeignete, schalenförmige Fassung ausgebildet ist. Bei dieser Lösung ist der zylindrische Dauermagnet durch den Halter 12 weitgehend gekapselt und vor mechanischen Beschädigungen geschützt. Außerdem kann der Dauermagnet unmittelbar auf der Leiterplatte befestigt werden. Ein in der Schalenwand 13 angebrachtes Fenster 14 dient dem Verschieben eines eingelegten Dauermagneten, dessen Länge, um ein Verschieben zu ermöglichen, um ein gewisses Maß kleiner sein muß als der Abstand der Stirnwände 15 und 16 des Halters 12. Außerdem dient das Fenster 14 dem Angeben eines Klebstofftropfens zum Befestigen des Dauermagneten im Halter 12. Die mit 17 und 18 bezeichneten Rastklinken wirken in gleicher Weise wie die am Halter 2 ausgebildeten Rastklinken 8 und 9. Die Fixierzapfen 19 und 20 sind bei dem Ausführungsbeispiel gemäß den Fig. 4 und 5 an den Stirnwänden 15 und 16 angeformt.

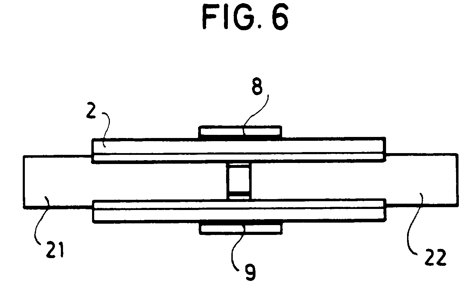

Die Fig. 6 zeigt eine Ausführungsvariante, bei der in dem Halter 2 zwei Dauermagnete 21 und 22 befestigt sind. In diesem Falle ist durch die zusätzliche, gegenseitige Verschiebbarkeit der Dauermagnete 21 und 22 eine flexiblere Justierung des betreffenden Magnetkreises gegeben.

## Patentansprüche

1. Halter (2) zum Befestigen eines stabförmigen Dauermagneten (1) auf einer Platine insbesondere auf einer Leiterplatte (3)
**dadurch gekennzeichnet,**
daß an dem Halter (2) eine der Aufnahme des Dauermagneten (1) dienende Fassung ausgebildet ist, die ein Verschieben des Dauermagneten (1) entlang einer Achse der Fassung gestattet,
daß dem Halter (2) zwei Fixierzapfen (10, 11) zum Fixieren des Halters auf der Platine derart zugeordnet sind, daß diese am jeweiligen Ende der Fassung angeformt sind und quer zur Achse der Fassung weisen und
daß an dem Halter (2) wenigstens eine in gleiche Richtung wie die Fixierzapfen (10, 11) weisende Rastklinke (8 bzw. 9) zur Verbindung mit der Platine ausgebildet ist.

2. Anordnung nach Anspruch 1,
dadurch gekennzeichnet,
daß der Halter (2) im wesentlichen U-förmig profiliert ist und die Fixierzapfen (10, 11) und wenigstens eine Rastklinke (8 bzw. 9) an der den Schenkeln (4, 5) des U-Profils entgegengesetzten Seite des Halters (2) ausgebildet sind.

3. Anordnung nach Anspruch 1,
dadurch gekennzeichnet,
daß der Halter (12) schalen- oder schellenförmig ausgebildet ist und
daß die Fixierzapfen (19, 20) und wenigstens eine Rastklinke (17 bzw. 18) an der Seite des Halters (12) ausgebildet sind, an welcher die den Dauermagneten aufnehmende Öffnung vorgesehen ist.

## Claims

1. Holder (2) for fastening a bar-shaped permanent magnet (1) on a board, in particular on a printed circuit board (3),
characterised
in that there is constructed on the holder (2) a mount which serves to receive the permanent magnet (1) and permits displacement of the permanent magnet (1) along an axis of the mount,
in that the holder (2) is assigned two locating pins (10, 11), for locating the holder on the board, in such a way that the said locating pins are integrally formed on the respective end of the mount and point transversely with respect to the axis of the mount and
in that there is constructed on the holder (2) at least one latching catch (8 and 9 respectively) which points in the same direction as the locating pins (10, 11) and is intended for connection to the board.

2. Arrangement according to Claim 1,
characterised
in that the holder (2) is of substantially U-shaped profile and the locating pins (10, 11) and at least one latching catch (8 and 9 respectively) are constructed on that side of the holder (2) opposite the sides (4, 5) of the U-profile.

3. Arrangement according to Claim 1,
characterised
in that the holder (12) is constructed in the form of a shell or clip and
in that the locating pins (19, 20) and at least one latching catch (17 and 18 respectively) are constructed on that side of the holder (12) on which the opening which receives the permanent magnet is provided.

## Revendications

1. Support (2) pour la fixation d'un aimant permanent en forme de bâtonnet (1) sur une platine, tout particulièrement sur une platine à circuits imprimés (3)
caractérisé par le fait
que sur ledit support (2) est formé un châssis servant au logement dudit aimant permanent (1) qui permet un déplacement dudit aimant permanent (1) le long d'un axe dudit châssis,
qu'audit support (2), deux broches de fixation (10, 11) destinées à la fixation dudit support sur ladite platine sont asociées de telle sorte que ces dernières sont moulées sur l'extrémité respective dudit châssis et se dirigent transversalement à l'axe dudit châssis et que sur ledit support (2) est moulé, pour l'assemblage avec la platine, au moins un cliquet d'arrêt (8 ou 9) dirigé dans le même sens que lesdites broches de fixation (10, 11).

2. Arrangement selon la revendication 1,
caractérisé par le fait
que le support (2) présente, pour l'essentiel, un profil en U et
que les broches de fixation (10, 11) ainsi qu'au moins un cliquet d'arrêt (8 ou 9) sont formés sur la face du support (2) qui est opposée aux montants (4, 5) du profil en U.

3. Arrangement selon la revendication 1,
caractérisé par le fait
que le support est réalisé en forme de cuvette ou de bride et
que les broches de fixation (19, 20) ainsi qu'au moins un cliquet d'arrêt (17 ou 18) sont formés sur la face du support (12) sur laquelle est prévue l'ouverture logeant l'aimant permanent.
